# EUROPEAN PATENT APPLICATION

(11) **EP 3 432 697 A1**
(43) Date of publication of application: **23.01.2019**
(21) Application number: 18179341.5
(22) Date of filing: 22.06.2018
(51) Int. Cl.: H05K 7/20

(54) **FAN FRONT INTAKE FOR SERVER FAN MODULE**

(30) Priority: 20.07.2017 US 201762534842 P; 26.03.2018 US 201815935853
(71) Applicant: Quanta Computer Inc., Taoyuan City 333 (TW)
(72) Inventor: CHEN, Chao-Jung, Taoyuan City (TW); HUANG, Yu-Nien, Taoyuan City (TW); WU, Kuen-Hsien, Taoyuan City (TW); LEE, Kuo-Wei, Taoyuan City (TW)
(74) Representative: D Young & Co LLP

(57) **Abstract**

A cooling system for providing streamlined airflow is provided. The system includes a fan with a plurality of fan blades configured to rotate in a fan direction. The system also includes a shroud component abutting the fan upstream. The shroud component includes a plurality of blade fairings, a spinner fairing, and optionally a strut interconnecting each of the plurality of blade fairings.

## Description

### FIELD OF THE INVENTION

This application relates to cooling systems, and more particularly to a cooling system with improved airflow.

### BACKGROUND

Computer server systems in modern data centers are commonly mounted in specific configurations on server racks for which a number of computing modules, such as server trays, server chassis, server sleds, server blades, etc., are positioned and stacked on top of each other within the server racks. Rack mounted systems allow for vertical arrangement of the computing modules to use space efficiently. Generally, each computing module can slide into and out of the server rack, and various cables such as input/output (I/O) cables, network cables, power cables, etc., connect to the computing modules at the front or rear of the rack. Each computing module contains one or more computer servers or may hold one or more computer server components. For example, computing modules includes hardware circuitry for processing, storage, network controllers, disk drives, cable ports, power supplies, etc.

In many configurations, fans in rack mounted systems are configured to move air from the front of a chassis enclosure through the computing modules and other components, and exhaust the air out the back of the chassis enclosure. Many electronic components generate heat when operating. Because of the high density of the computing modules in the chassis, a significant amount of heat is generated by the computing modules. Therefore, the flow of air through the chassis enclosure is essential for preventing the overheating of the computing modules. Accordingly, there is a significant interest in improving fan performance for computer server systems and other types of computing devices.

### SUMMARY

The following is a simplified summary of one or more embodiments in order to provide a basic understanding of present technology. This summary is not an extensive overview of all contemplated embodiments of the present technology. Its sole purpose is to present some concepts of one or more examples in a simplified form as a prelude to the more detailed description that is presented later. Particular and preferred aspects of the present invention are set out in the accompanying independent and dependent claims. Features of the dependent claims may be combined with features of the independent claims as appropriate, and in combinations other than those explicitly set out in the claims.

A cooling system for providing streamlined airflow is provided. The system includes a fan with a plurality of fan blades configured to rotate in a fan direction. The system also includes a shroud component abutting the fan upstream. The shroud component includes a plurality of blade fairings, a spinner fairing, and optionally a strut interconnecting each of the plurality of blade fairings.

In some implementations, the spinner fairing extends from a center section of the shroud component. In some implementations, each of the blade fairings includes a reverse blade fairing extended from a center section of the shroud component. In some implementations, each of the fan blades includes a leading fan edge facing towards the fan direction and a trailing fan edge facing against the fan direction. In some implementations, each of the blade fairings includes a cross-section shaped as a curved wedge. The cross-section creates an intake flow channel of varying angles that prevent vortexes in front of the shroud component. In some implementations, a center section of the shroud component aligns with a center section of the fan.

In some implementations, the spinner fairing includes a cone shape. The cone shaped spinner fairing decreases turbulent airflow at an inlet side of the fan. In some implementations, the spinner fairing includes a half spherical shape. The half spherical shaped spinner fairing decreases turbulent airflow at an inlet side of the fan. In some implementations, the strut improves rotation of irregular vortexes at an intake of the fan.

A shroud component configured to abut a fan upstream is provided. The shroud component includes a plurality of blade fairings, a spinner fairing, and a strut interconnecting each of the plurality of blade fairings.

### BRIEF DESCRIPTION OF THE DRAWINGS

In order to describe the manner in which the above-recited and other advantages and features of the disclosure can be obtained, a more particular description of the principles described above will be rendered by reference to specific examples illustrated in the appended drawings. These principles are described and explained with additional specificity and detail through the use of the following drawings.
FIG. 1 illustrates a simplified block diagram of an example cooling system in the prior art;
FIG. 2 illustrates a side view of paths of airflow in the example cooling system of FIG. 1 in the prior art;
FIG. 3 illustrates a front view of an example cooling system in a server chassis in the prior art;
FIG. 4A illustrates a front view of an exemplary shroud component;
FIG. 4B illustrates a cross-sectional view of an exemplary shroud component;
FIG. 4C illustrates an isometric view of an exemplary shroud component;
FIG. 4D illustrates a simplified block diagram of a spinner fairing of the exemplary shroud component of FIGS. 4A-C;
FIG. 4E illustrates an isometric view of an exemplary shroud component installed on a fan;
FIG. 5A shows an isometric view of the exemplary shroud component of FIGS. 4A and 4B installed on the fan ; and
FIG. 5B illustrates a cross-section view of the exemplary shroud component installed on the fan.

### DETAILED DESCRIPTION

The present invention is described with reference to the attached figures, wherein like reference numerals are used throughout the figures to designate similar or equivalent elements. The figures are not drawn to scale and are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details, or with other methods. In other instances, well-known structures or operations are not shown in detail to avoid obscuring the invention. The present invention is not limited by the illustrated ordering of acts or events, as some acts may occur in different orders and/or concurrently with other acts or events. Furthermore, not all illustrated acts or events are required to implement a methodology in accordance with the present invention.

Various server chassis designs are used to accommodate a large number of hard disk drives, motherboards, and fans. The various server chassis designs often place particular computer modules in different positions in the server chassis to improve airflow and cooling. A component that lies upstream of a fan will generate irregular vortexes downstream. These irregular vortexes cause energy loss and thermal performance drop. The disclosure provides a cooling system that mitigates irregular vortexes upstream of fans. The cooling system can be applied in a computer system, such as a server chassis, or in other devices.

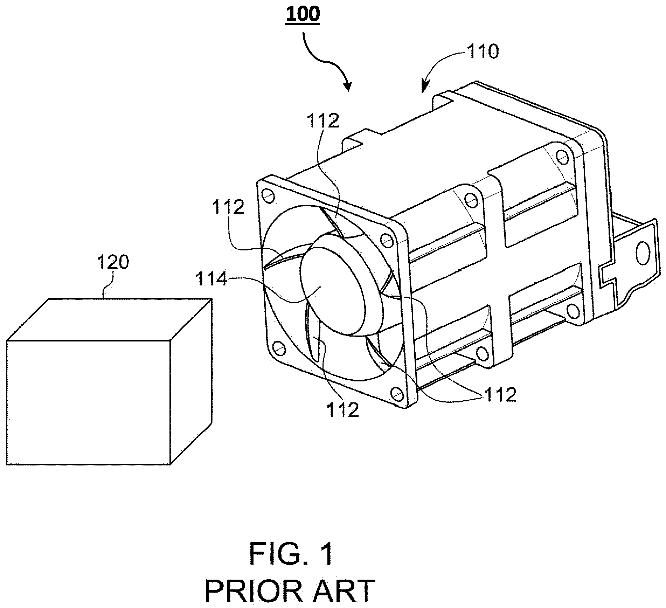

FIG. 1 illustrates a front view of an example cooling system 100 in the prior art. The cooling system 100 includes a fan 110 and a system component 120. The fan 110 is configured to draw air over and around the system component 120. For example, the fan 110 can be a standard fan, which is commonly square shaped. Some standard square dimensions can include 80 mm, 92 mm, 200 mm, 230 mm, 320 mm, or 340 mm, in width and length. Although square dimensions listed herein are industry standard, it should be noted that any dimensions can be implemented. Typically, when larger fans are used, fewer fans and less rotation speed are needed to produce an equivalent amount of airflow as compared to using smaller fans.

The fan 110 includes a plurality of fan blades 112 (e.g., four fan blades 112 are shown). The fan 110 includes a center fan section 114 by which each of the plurality of fan blades 112 is attached. When in operation, the center fan section 114 and the fan blades 112 rotate either clockwise or counter-clockwise. The fan 110 can be powered by an electric motor (not shown) connected to the center fan section 114. The fan blades 112 can be implemented in a wide variety of shapes and sizes. For example, each of the fan blades 112 can have a flat planar shape or a curved planar shape. However, the present disclosure contemplates that any size or shape can be used for fan blades 112.

Each of the fan blades 112 is attached to the center fan section 114 at an angle that allows the fan blade to draw air over and around the system component 120 when the fan 110 is rotated during operation.

The system component 120 is located upstream of the fan 110. The system component 120 is any object that acts as an obstacle to airflow to the fan 110. For example, the system component 120 can be a printed circuit board (PCB) that provides connections between various components of a server chassis. The system component 120 includes a cutout (not shown) to allow air to flow past the system component 120 towards the fan 110.

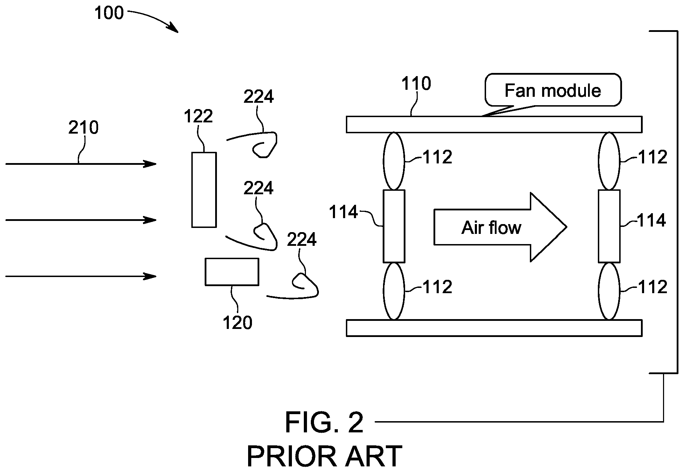

FIG. 2 illustrates a side view of paths of airflow in the example cooling system 100 of FIG. 1 in the prior art. The cooling system 100 includes a fan 110 and a system component 120.

The fan 110 in the example cooling system 100 shown includes two rotors that are located in-line with each other, but similar principles apply to single rotor fans. Each rotor includes a plurality of fan blades 112 and a center fan section 114. The fan 110 draws airflow in 210 to allow air to flow past the system component 120.

The system component 120 is located upstream of the fan 110. The system component 120 includes a bridge 122 that spans the cutout. The bridge 122 specifically acts as an obstacle to the airflow 210 drawn in towards the fan 110. The bridge 122 causes turbulent airflow 224 on both sides of the bridge 122 that causes energy loss and thermal performance drop.

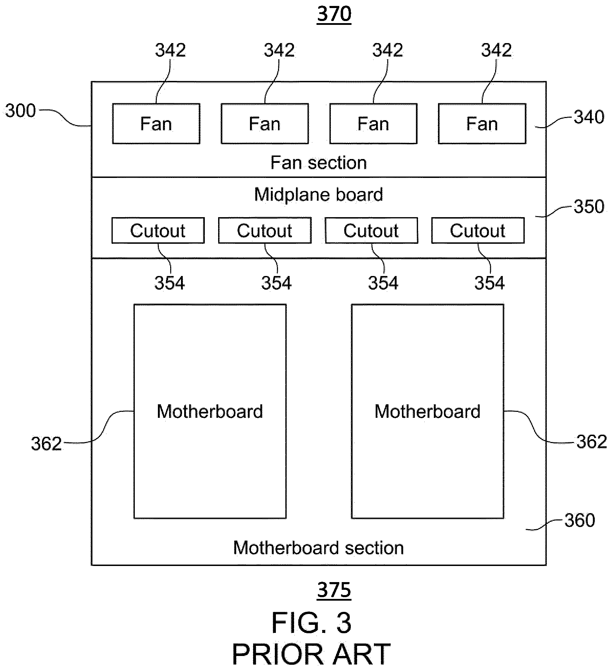

FIG. 3 illustrates a front view of an example cooling system in a server system 300 in the prior art. In some implementations, the server system 300 is a part of a larger rack system. The example server system 300 includes a fan section 340, a motherboard section 360, and a midplane board 350.

The fan section 340 includes one or more fans 342 that draw air from inlet 370 through the server system 300 and towards outlet 375. The air is pulled from the motherboard section 360 towards the fan section 340. The fans 342 cause air to be pulled through the midplane board 350 from the motherboard section 360.

The motherboard section 360 includes one or more motherboards 362 (also known as mainboard, system board, planar board, or logic board). Each motherboard 362 is a main printed circuit board (PCB) found in computers and other expandable systems. The motherboard 362 holds and allows communication between many electronic components (not shown) of a computer system, such as the central processing unit (CPU) and memory, and provides connectors for other peripherals.

The midplane board 350 is located between the fan section 340 and the motherboard section 360. The midplane board 350 provides connections to the one or more motherboards 362. In some aspects, the midplane board 350 is a printed circuit board (PCB) that includes hot pluggable connectors that allow insertion of each of the motherboards 362. The midplane board 350 connects to the backplane board (not shown) to provide the motherboards 362 with power. The midplane board 350 includes at least one cutout 354 for allowing air to flow from the motherboard section 360 to the fan section 340. Each cutout 354 of midplane board 350 includes a bridge (not shown). The midplane board 350 is an example of the system component 120 that causes turbulent airflow as described in FIGS. 1-2.

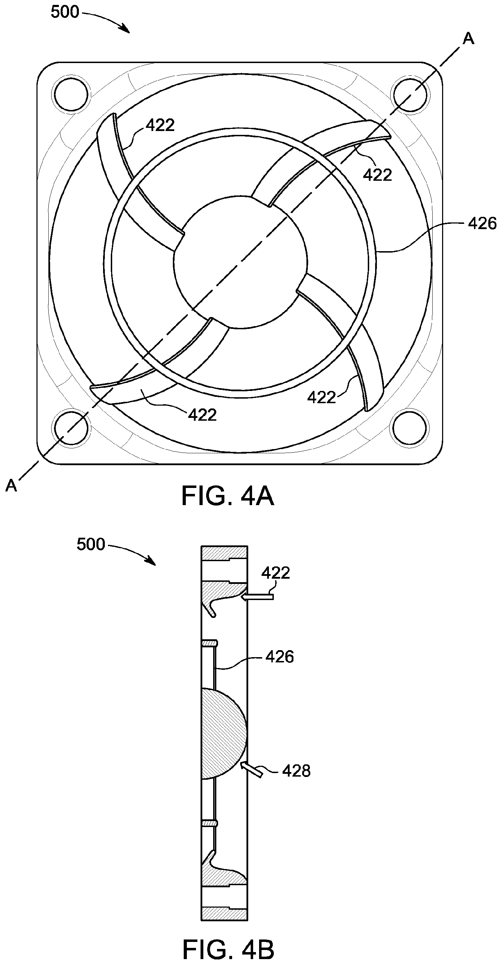

However, while components can be arranged in a server chassis to improve airflow, the typical cutout shapes implemented in a server chassis introduce turbulence that causes energy loss and thermal performance drop. To further improve airflow, a shroud is implemented. The shroud can include a combination of blade fairings, a strut, and a spinner fairing. This is illustrated in FIGS. 4A-B.

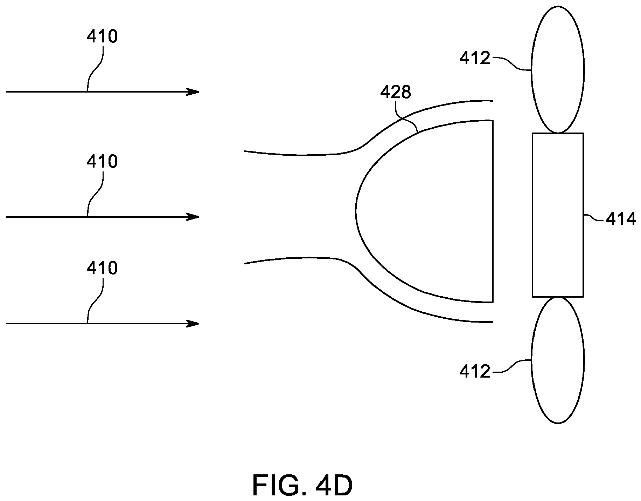

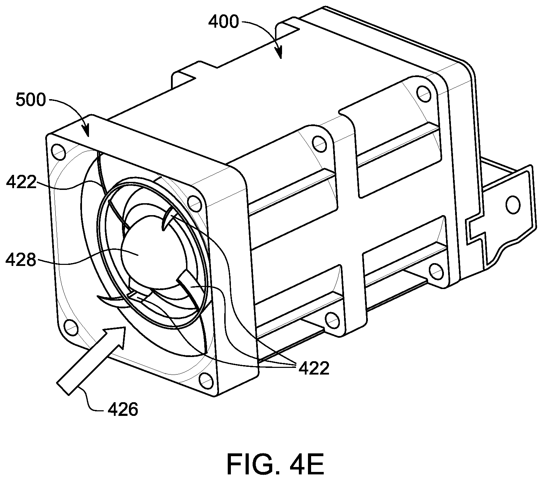

FIGS. 4A-C illustrate front, cross-section, and isometric views of an exemplary shroud component 500. The shroud component 500 can include a strut 426, a spinner fairing 428, and plurality of blade fairings 422. FIG. 4D illustrates a simplified block diagram of the spinner fairing 428 of the exemplary shroud component 500 of FIGS. 4A-C. The shroud component 500 can be located adjacent or upstream of the fan 400. FIG. 4E illustrates an isometric view of an exemplary shroud component 500 installed on a fan 400.

The spinner fairing 428 is a part of or an addition to the center section of the shroud component 500. In some implementations, the spinner fairing 428 is circular shaped. The spinner fairing 428 may be aligned with the center fan section 414. In some implementations, the spinner fairing 428 is cone shaped. In some implementations and as shown herein, the spinner fairing 428 has a half spherical shape. It is understood that the spinner fairing 428 can be of any shape that decreases turbulent airflow as a result of the vortex upstream of the center section of the intake side of the fan 400.

For example, as shown in FIG. 2, when airflow 210 flows through the non-streamlined object, in this case, bridge 122, the airflow 210 is separated from the non-streamlined object, to create a vortex. The vortex is indicated by turbulent airflow 224. The vortex can produce fluid resistance to decrease the thermal performance of the fan 110. Referring to FIG. 4D, the spinner fairing 428 is accompanied with a plurality of fan blades 412 (e.g., two fan blades 412 are shown). The plurality of fan blades 412 is connected to a center fan section 414 by which each of the plurality of fan blades 412 is attached. As the airflow 410 approaches the spinner fairing 428, the airflow 410 is guided along the surface of the spinner fairing 428 towards the plurality of fan blades 412. The spinner fairing 428 provides a more streamlined shape that reduces or eliminates the turbulent airflow. In reducing or eliminating the turbulent airflow, the thermal performance of the fan is drastically improved.

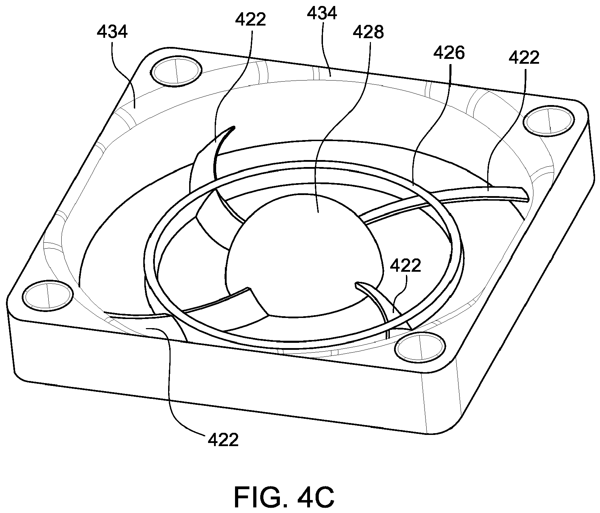

In some embodiments, each blade fairing 422 has a cross-section shaped as a curved wedge. As shown in FIG. 4C, this creates an intake flow channel of varying angles 434. The varying angles 434 change and prevent vortexes in front of the shroud component 500 by designing a streamlined bullet model similar to the spinner fairing 428 as discussed above with respect to FIG. 4D. This enables increased airflow and reduction in energy loss. Furthermore, the strut 426 improves the rotation of the irregular vortexes at the intake of the fan 400, such that the rotation of the vortexes match that of the fan 400. It should be understood that the shroud component 500 can include any combination of the strut 426, a spinner fairing 428, and the plurality of blade fairings 422.

Referring now to FIG. 4E, the blade fairings 422 can be implemented in conjunction with fan blades of the fan 400. Each of the fan blades can be attached to the center fan section at a blade angle (i.e., blade angle in relation to an axle of rotation of the fan) that allows the fan blade to draw air from a system component when the fan 400 is rotated during operation. Each blade fairing 422 can be attached to the center section of the shroud component 500 at a faring angle approximately reverse of the blade angle.

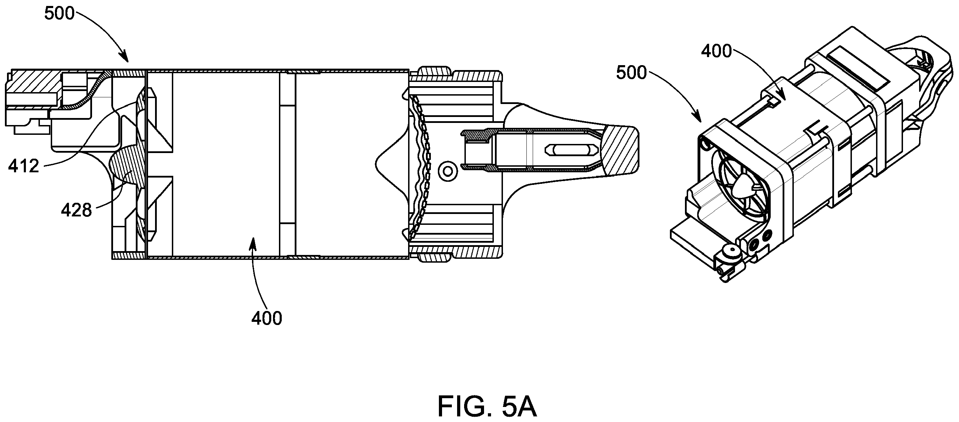

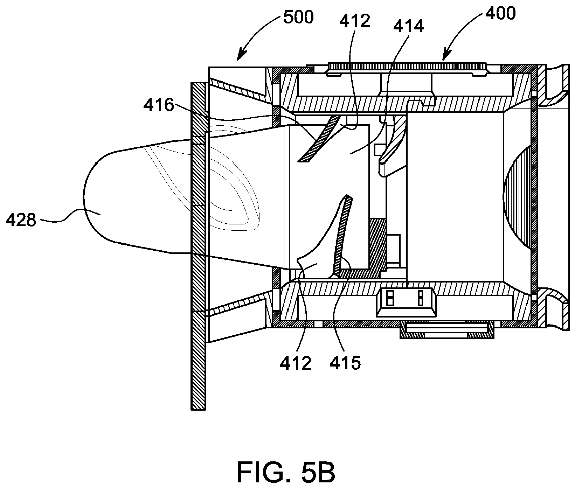

FIG. 5A shows the exemplary shroud component 500 installed on a fan 400. FIG. 5B illustrates a cross-section view of an exemplary shroud component 500 installed on a fan 400. The fan 400 includes a plurality of fan blades 412. The fan 400 includes a center fan section 414 to which each of the plurality of fan blades 412 is attached. When in operation, the fan 400 rotates the center fan section 414 and the fan blades 412 in either a clockwise or counter-clockwise direction.

The fan 400 is powered by an electric motor (not shown) connected to the center fan section 414. The fan blades 412 are available in a wide variety of shapes and sizes. For example, each of the fan blades 412 may have a flat planar shape or a curved planar shape. However, the present disclosure contemplates that other shapes can be used as well.

Each fan blades 412 includes a leading fan edge 415 facing towards the fan direction and a trailing fan edge 416 facing against the fan direction. Each of the fan blades 412 are attached to the center fan section 414 at a blade angle (i.e., blade angle in relation to an axle of rotation of the fan) that allows the fan blade to draw air towards the system component (shown in FIGS. 1 and 2) when the fan 400 is rotated during operation. The shroud component 500 is located upstream of the fan 400. The shroud component 500 can abut the fan 400 or can be nominally spaced from the fan 400.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

## Claims

1. A cooling system for providing streamlined airflow, **characterized by** comprising:
a fan (400) comprising a plurality of fan blades (412) and configured to rotate in a fan direction; and
a shroud component (500) abutting the fan (400) upstream, comprising a plurality of blade fairings (422) and a spinner fairing (428).

2. The cooling system of claim 1, **characterized in that** the spinner fairing (428) is disposed on a center section of the shroud component (500).

3. The cooling system of claim 1 or claim 2, **characterized in that** each of the plurality of blade fairings (422) comprises a reverse blade fairing extended from a center section of the shroud component (500).

4. The cooling system of any of claims 1-3, **characterized in that** each of the plurality of fan blades (412) comprises a leading fan edge (415) facing towards the fan direction and a trailing fan edge (416) facing against the fan direction.

5. The cooling system of any of claims 1-4, **characterized in that** each of the plurality of blade fairings (422) comprises a cross-section shaped as a curved wedge.

6. The cooling system of claim 5, **characterized in that** the cross-section creates an intake flow channel of varying angles (434).

7. The cooling system of any of claims 1-6, **characterized in that** a center section of the shroud component (500) aligns with a center section (414) of the fan (400).

8. The cooling system of any of claims 1-7, **characterized in that** the spinner fairing (428) comprises a cone shape or a half spherical shape.

9. The cooling system of any of claims 1-8, **characterized by** further comprising a strut (426) interconnecting each of the plurality of blade fairings (422).

10. A shroud component (500) configured to abut a fan (400) upstream, the shroud component (500) **characterized by** comprising:
a plurality of blade fairings (422);
a spinner fairing (428); and
a strut (426) interconnecting each of the plurality of blade fairings (422).

11. The shroud component (500) of claim 10, **characterized in that** the spinner fairing (428) is disposed on a center section of the shroud component (500).

12. The shroud component (500) of claim 10 or claim 11, **characterized in that** each of the plurality of blade fairings (422) comprises a reverse blade fairing extended from a center section of the shroud component (500).

13. The shroud component (500) of any of claims 10-12, **characterized in that** each of the plurality of blade fairings (422) comprises a cross-section shaped as a curved wedge.

14. The shroud component (500) of claim 13, **characterized in that** the cross-section creates an intake flow channel of varying angles (434).

15. The shroud component (500) of any of claims 10-14, **characterized in that** the spinner fairing (428) comprises a cone shape or a half spherical shape.
